# EUROPEAN PATENT SPECIFICATION

(11) **EP 0 326 749 B1**
(45) Date of publication and mention of the grant of the patent: **09.03.1994**
(21) Application number: 88311028.0
(22) Date of filing: 22.11.1988
(51) Int. Cl.: G01R 33/06, G11B 5/39

(54) **Magneto-resistive sensor element**
Magnetoresistives Fühlerelement
Elément pour capteur magnétorésistif

(30) Priority: 05.02.1988 US 152792
(43) Date of publication of application: 09.08.1989
(73) Proprietor: SEAGATE TECHNOLOGY INTERNATIONAL, Georgetown, Grand Cayman Island (KY)
(72) Inventor: Mowry, Gregory Stephen, Burnsville Minnesota 55337 (US); Mitchell, Terry Blake, Minneapolis Minnesota 55435 (US); Tolman, Charles Henry, Bloomington Minnesota 55431 (US); George, Peter Kurt, Bloomington Minnesota 55438 (US)
(74) Representative: Miller, Joseph

(56) References cited:
- US-A- 4 556 925
- US-A- 4 731 757
- IBM TECHNICAL DISCLOSURE BULLETIN. vol. 7, no. 6, November 1964, NEW YORK US page 490 R.F.PENOYER: "Thin Film Memory Element Demagnetization Reduction Method"
- PATENT ABSTRACTS OF JAPAN Vol.12 Nr 100, (P683) 2 april 88 &JP-A-62232719

## Description

This invention relates to magneto-resistive sensor elements, for example, for incorporation into magneto-resistive heads.

The output of a magneto-resistive sensor element is adversely affected by multiple magnetic domains in a sense region, because the walls of the magnetic domain suddenly move under influence of the magnetic fields being sensed. This sudden movement of the domain walls causes an uneven response in the output of the sensor element, limiting its usefulness. Efforts have been made to provide a single magnetic domain in the sense region during sensor "read" operations to avoid Barkhausen noise. Among these efforts have been efforts to shape the sensor element in such a manner that there is a single magnetic domain in the sense region.

One example of such shaping is the so-called football-shaped sensor element (US-A-4,556,925 and EP-A-0,279,537, this European Patent Application having been published on 24.8.88 and therefore falling under Article 54(3) EPC). The football-shaped sensor element has a highly stable central single magnetic domain. However, experience has shown that even this sensor element can be fractured into two horizontal domains under the influence of high external magnetic fields (such as one may find if the sensor element is incorporated into a read/write head) which drives the sensor element into saturation of the hard axis of magnetisation. Further, routine photo-lithic process variations can significantly blunt the end points of the football-shape, thereby eliminating the very geometry which stabilised the central single magnetic domain.

The present invention seeks to provide a magnetoresistive sensor element which has a stable central single magnetic domain which re-establishes itself even after a central region has been saturated in the direction of the hard axis of magnetisation, and is maintained irrespective of photo-lithic processes used in the manufacture of the sensor element.

According to one aspect of the present invention, there is provided a magneto-resistive sensor element which has a central region (12;22), said central region being relatively wide compared to neck regions (16;26,30) and a transition region (14;24,28) between each neck region and the central region, said neck regions having sides substantially parallel to the sides of said central region.

In one embodiment, the magneto-resistive sensor element is symmetrical about a centre line. In another embodiment the transition regions are skewed relative to a centre line.

Preferably the transition regions each have at least one side inclined to the opposed parallel sides of the central region. In one embodiment, an easy axis of magnetisation is oriented in a direction parallel to the opposed parallel sides of the central region. In another embodiment, an easy axis of magnetisation is oriented in a direction at an angle to the opposed parallel sides of the central portion.

According to another aspect of the present invention, there is provided a bottleneck magneto-resistive element which has a central wide portion (12;22) with two ends, a narrowing transition portion (14;24,28) connected to each end with at least one inclined side (32,34), and a bottleneck portion (16;26,30) connected to each transition portion, the bottleneck portion having a width less than the central wide portion and being substantially rectangular in shape with the sides of the rectangle's long dimension being substantially parallel with the opposed parallel sides of said central region.

The invention is illustrated, merely by way of example, in the accompanying drawings, in which:-
Figure 1 is a partial plan view of one embodiment of a magneto-resistive sensor element according to the present invention; and
Figure 2 is a plan view of another embodiment of a magneto-resistive sensor element according to the present invention.

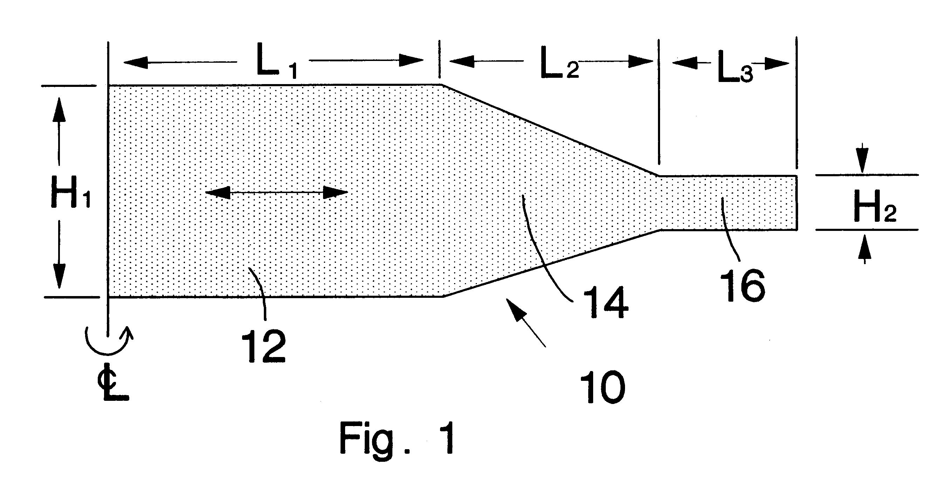

Referring first to Figure 1, there is shown one embodiment of a magneto-resistive sensor element 10 according to the present invention. The sensor element is planar and is symmetrical about a centre line CL. The sensor element is also symmetrical or substantially symmetrical (as shown) about a centre line extending in the length direction. The half of the sensor element shown in Figure 1 comprises three regions, namely, a relatively wide central region 12 with opposed parallel sides, a transition region 14 with inwardly inclined sides, and a relatively narrow neck region 16 of generally rectangular shape.

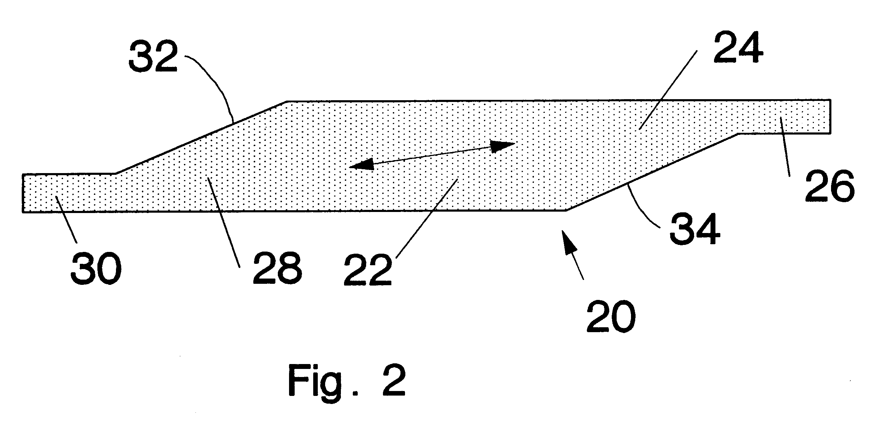

The preferred material for the magneto-resistive sensor element is nominally 18:20 nickel-iron alloy. However, it may be constructed from any appropriate magneto-resistive material. The easy axis of magnetisation of the material of the sensor element is normally oriented along the axis or length direction of the sensor element 10 (parallel to the sides of the central region 12 as indicated by the arrow in Figure 1), but may be skewed slightly as in the embodiment shown in Figure 2. That is, the easy axis of magnetisation in both embodiments may be parallel or skewed, depending upon the application for the sensor element; skewing slightly linearises the output of a magneto-resistive head employing the sensor element.

The following are experimentally derived parameters for the lengths and heights of the three regions 12, 14, 16, the parameters being indicated in Figure 1.

| PARAMETER | RANGE (µm) | PRACTICAL LIMITS (µm) |
|---|---|---|
| H₁ | 2 - 15 | 4 - 10 |
| H₂ | 1 - 3 | 1 - 3 |
| L₁ | 0 - ∞ | 5 - 50 |
| L₂ | 10 - ∞ | 15 - 25 |
| L₃ | 5 - 25 | 10 - 20 |
| THICKNESS | 50 - 1000 A° | 150 - 700 A° |

It will be appreciated that conductors (not shown) for sensing the change in resistivity of the sensor element under the influence of an external magnetic field are provided as shown, for example, in Figure 5 of US-A-4,556,925 or Figure 12 of EP-A-0,279,537.

Figure 2 shows another embodiment of a magneto-resistive sensor element 20 according to the present invention. This embodiment is not symmetrical about a centre line. Rather, on one side, a first neck 30 occurs on the lower (as shown in Figure 2) half of the sensor element and a neck 26 occurs on the upper half of the sensor element. Essentially, transition regions 24,28 are skewed relative to one another. The sensor element has a relatively wide central region 22 with opposed parallel sides. The transition regions 24,28 are skewed relative to one another with a respective inclined side 34,32 leading to the respective necks 26,30. If the necks 26,30 are arranged so that one side is flush with a side of the central region 22, as shown in Figure 2, then the respective transition regions 24,28 include only one inclined side, 34 or 32 respectively. However, a construction where the sides of the necks are not flush with the central region are contemplated. In such a construction, the transition regions 24,28 will have two inclined sides as in the embodiment shown in Figure 1. The easy axis of magnetisation shown by the arrow in Figure 2 may or may not be skewed relative to the parallel sides of the central region.

## Claims

1. A magneto-resistive sensor element which has a central region (12;22), said central region being relatively wide compared to neck regions (16;26,30) and a transition region (14;24,28) between each neck region and the central region, said neck regions having sides substantially parallel to the sides of said central region.

2. A magneto-resistive sensor element as claimed in claim 1, wherein the transition regions (14;24,28) each have at least one side (32,34) inclined to the opposed parallel sides of the central region (12;22).

3. A magneto-resistive sensor element as claimed in claim 1 wherein both the transition regions (24,28) are skewed relative to a centre line substantially parallel with the parallel sides of said central wide region (12;22).

4. A magneto-resistive sensor element as claimed in claim 1 and 2, which is symmetrical about a centre line which is substantially parallel with the parallel sides of said central wide region (12;22).

5. A magneto-resistive sensor element as claimed in claim 4 wherein an easy axis of magnetisation is oriented in a direction parallel to the opposed parallel sides of the central region (12).

6. A magneto-resistive sensor element as claimed in claim 1 or 2 wherein an easy axis of magnetisation is oriented in a direction at an angle to the opposed parallel sides of the central portion (22).

7. A bottleneck magneto-resistive element which has a central wide portion (12;22) with two ends, a narrowing transition portion (14;24,28) connected to each said end with at least one inclined side (32, 34), and a bottleneck portion (16;26,30) connected to each transition portion, the bottleneck portion having a width less than the central wide portion and being substantially rectangular in shape with the sides of the rectangle's long dimension being substantially parallel with the opposed parallel sides of said central region.

8. A magneto-resistive element as claimed in claim 7 wherein the shape is symmetrical about a centre line substantially parallel with the parallel sides of said central wide portion (12;22).

## Patentansprüche

1. Magnetoresistives Sensorelement, das einen Mittelbereich (12;229, der verglichen mit Halsbereichen (16;26,30) relativ breit ist, und einen Übergangsbereich (14;24,28) zwischen jedem Halsbereich und dem Mittelbereich aufweist, wobei die Halsbereiche Seiten aufweisen, die im wesentlichen parallel zu den Seiten des Mittelbereiches verlaufen.

2. Magnetoresistives Sensorelement nach Anspruch 1, bei dem die Übergangsbereiche (14;24,28) jeweils zumindestens eine Seite (32,34) aufweisen, die gegenüber den gegenüberliegenden parallelen Seiten des Mittelbereiches (12;22) geneigt ist.

3. Magnetoresistives Sensorelement nach Anspruch 1, bei dem beide Übergangsbereiche (24,28) gegenüber einer Mittellinie schrägverlaufend angeordnet sind, die im wesentlichen parallel zu den parallelen Seiten des breiten Mittelbereiches (12;22) ist.

4. Magnetoresistives Sensorelement nach Anspruch 1 oder 2, das um eine Mittellinie symmetrisch ist, die im wesentlichen parallel zu den parallelen Seiten des breiten Mittelbereiches (12;22) verläuft.

5. Magnetoresistives Sensorelement nach Anspruch 4, bei der eine magnetiche Vorzugsrichtung in einer Richtung parallel zu den gegenüberliegenden parallelen Seiten des Mittelbereiches (12) ausgerichtet ist.

6. Magnetoresistives Sensorelement nach Anspruch 1 oder 2, bei dem eine magnetische Vorzugsrichtung in einer Richtung unter einem Winkel zu den gegenüberliegenden parallelen Seiten des Mittelbereiches (22) angeordnet ist.

7. Flaschenhalsförmiges magnetoresistives Element, das einen breiten Mittelbereich (12;22) mit zwei Enden, einen mit jedem der Enden verbundenen, sich verengenden Übergangsbereich (14;24, 28) mit zumindestens einer geneigten Seite (32,34) und einen mit jedem Übergangsbereich verbundenen Flaschenhalsteil (16;26, 30) aufweist, wobei der Flaschenhalsteil eine kleinere Breite als der breite Mittelbereich aufweist und eine im wesentlichen rechtwinklige Form hat, wobei die Seiten der langen Abmessung des Rechteckes im wesentlichen parallel zu den gegenüberliegenden parallelen Seiten des Mittelbereiches angeordnet sind.

8. Magnetoresistives Element nach Anspruch 7, bei dem die Form symmetrisch um eine Mittellinie ist, die im wesentlichen parallel zu den parallelen Seiten des breiten Mittelbereiches (12;22) ist.

## Revendications

1. Elément capteur magnéto-résistif qui a une zone centrale (12 ; 22), ladite zone centrale étant relativement étendue comparativement aux rebords (16 ; 26, 30) et une zone de transition (14 ; 24, 28) entre chaque rebord et la zone centrale, lesdits rebords ayant des côtés sensiblement parallèles aux côtés de ladite zone centrale.

2. Elément capteur magnéto-résistif selon la revendication 1, dans lequel les zones de transition (14 ; 24, 28) ont chacune au moins un côté (32, 34) en pente vers les côtés opposés parallèles de la zone centrale (12 ; 22).

3. Elément capteur magnéto-résistif selon la revendication 1, dans lequel les deux zones de transition (24, 28) sont inclinées par rapport à une ligne centrale sensiblement parallèle aux côtés parallèles de ladite zone centrale élargie (12 ; 22).

4. Elément capteur magnéto-résistif selon les revendications 1 et 2, qui est symétrique par rapport à une ligne centrale sensiblement parallèle aux côtés parallèles de ladite zone centrale élargie (12 ; 22).

5. Elément capteur magnéto-résistif selon la revendication 4, dans lequel un axe privilégié de magnétisation est orienté suivant une direction parallèle aux côtés opposés parallèles de la zone centrale (12).

6. Elément capteur magnéto-résistif selon la revendication 1 ou 2, dans lequel un axe privilégié de magnétisation est orienté suivant un certain angle par rapport aux côtés opposés parallèles de la zone centrale (22).

7. Elément magnéto-résistif en forme de goulot de bouteille ayant une zone centrale élargie (12 ; 22) avec deux extrémités, une zone de transition (14 ; 24, 28) se rétrécissant et étant raccordée à chacune desdites extrémités au moyen d'au moins un côté en pente (32, 34), et ayant une zone en forme de goulot de bouteille (16 ; 26, 30) raccordée à chaque zone de transition, la zone en forme de goulot de bouteille ayant une largeur inférieure à celle de la zone centrale élargie et étant sensiblement de forme rectangulaire avec les grands côtés du rectangle sensiblement parallèles aux côtés opposés parallèles de ladite zone centrale.

8. Elément magnéto-résistif selon la revendication 7, dans lequel la forme est symétrique par rapport à une ligne médiane sensiblement parallèle aux côtés parallèles de ladite zone centrale élargie (12 ; 22).
